# EUROPÄISCHE PATENTSCHRIFT

(11) **EP 1 108 513 B1**
(45) Veröffentlichungstag und Bekanntmachung des Hinweises auf die Patenterteilung: **17.05.2006**
(21) Anmeldenummer: 00118107.2
(22) Anmeldetag: 25.08.2000
(51) Int. Cl.: B29C 35/08, C21D 1/34, H05B 3/00

(54) **Vorrichtung und Verfahren zur thermischen Behandlung von Substratmaterial**
Apparatus and process for thermal treatment of substrate material
Appareil et procédé pour le traitement thermique de matériau de substrat

(30) Priorität: 27.08.1999 DE 19940838
(43) Veröffentlichungstag der Anmeldung: 20.06.2001
(73) Patentinhaber: Gerstendörfer-Hart, Barbara, 82544 Egling (DE); Ackermann, Gunther, 81737 München (DE)
(72) Erfinder: Hitschfel, Werner, 84562 Mettenheim (DE)

(56) Entgegenhaltungen:
- EP-A- 0 823 316
- DE-A- 3 023 838
- DE-A- 3 140 220
- DE-A- 3 734 443
- DE-A- 3 826 841
- DE-U- 29 606 991
- GB-A- 1 489 183
- US-A- 3 836 751
- US-A- 4 101 759
- US-A- 4 202 112
- US-A- 4 563 589
- US-A- 4 605 839
- US-A- 5 156 820
- US-A- 5 740 314

## Beschreibung

Die vorliegende Erfindung betrifft eine Vorrichtung zur thermischen Behandlung von Substratmaterial mit den im Oberbegriff des Patentanspruchs 1 angegebenen Merkmalen.

Die Erfindung betrift darüber hinaus ein Verfahren zur thermischen Behandlung von Substratmaterial mit den im Oberbegtiff des Patentanspruchs 13 angegebenen Merkmalen.

Derartige Vorrichtungen beziehungsweise Verfahren werden dazu verwendet, verschiedenste Arten von Substratmaterial thermisch zu behandeln, um einen vorangegangenen Verarbeitungsprozess abzuschließen, und/oder um das Substratmaterial auf weitere Verarbeitungsschritte vorzubereiten.

Eine gattungsmäßige Vorrichtung zur thermischen Behandlung von Substratmaterial ist unter anderem in der Schrift DE-OS 38 23 670 dargestellt, die jedoch die Erwärmung ausschließlich von Vorformlingen mittels direkter und indirekter Infrarotstrahlung betrifft. Die in einer Ausführungsform vorhandene Glasscheibe ist als Filter ausgelegt, gewährleistet jedoch keinen Explosionsschutz. Ferner ist der Reflektor nur als ebene Reflexionsfläche ohne strahlungslenkende Geometrie ausgelegt, weshalb eine energetisch homogene Immission am zu behandelnden Material nicht darstellbar ist; ferner sorgt die unvermeidliche Streustrahlung für energetische Verluste.

Eine weitere Vorrichtung ist aus der DE-OS 197 24 621 bekannt, die ebenfalls eine thermische Behandlung ausschließlich von Vorformlingen betrifft und bei der die Erwärmung des Materials allein durch Reflexion der von einer Heizeinrichtung emittierten Strahlung erfolgt. Diese Vorrichtung besitzt ebenfalls keinen Explosionsschutz. Durch die ausschließlich über Reflektoren erfolgende Beaufschlagung des zu behandelnden Materials mit Strahlung ergibt sich nur eine geringe Strahlungsdichte; das heißt, es ist eine hohe und unwirtschaftliche Heizleistung der eingesetzten Emittoren erforderlich.

Weiter bekannt sind Heiz-Vorrichtungen mit IR-Emittoren mit Keramik-Reflektoren, die jedoch in Folge ihrer Absorptionseigenschaften selbst zur Strahlungsquelle werden und somit eine schnelle Regelung der Immission am zu behandelnden Material erschweren.

Bekannte Heiz-Vorrichtungen besitzen zudem keinen wirksamen Schutz gegen Explosionsgefahr, der insbesondere beim Einsatz lösemittelhaltiger Materialien erforderlich ist. Weiterhin bekannte Heizvorrichtungen mit ausschließlichem Umluftbetrieb sind nicht zur Erzeugung der für den eingangs genannten Zweck notwendigen Energiedichten geeignet.

Die US-A-5740314 offenbart eine Vorrichtung zur Erwärmung von Wafern mit punktförmigen, birnenartigen Infrarotstrahlern und glockenartigen Reflektoren.

In der DE-A-3140220 wird eine Reflektoreinheit für Infrarotröhren mit u-förmigem Querschnitt beschrieben, welche auf ihrer zur Reflektorfläche entfernt liegenden Fläche Befestigungseinrichtungen und Kühlflansche aufweist.

Aufgabe der vorliegenden Erfindung ist es daher, eine Vorrichtung zur thermischen Behandlung von Substratmaterial bereit zu stellen, bei der die InfrarotStrahlung das zu erwärmende Material mit einer hohen, definierten Energiedichte und mit einer weitgehend homogenen energetischen Verteilung beaufschlagt und bei der in einer bevorzugten Ausführungsform zudem ein wirksamer Explosionsschutz gemäß bestimmter rechtlicher Vorschriften gewährleistet ist.

Erfindungsgemäß wird diese Aufgabe bei einer gattungsgemäßen Vorrichtung durch die im kennzeichnenden Teil des Patentanspruchs 1 angegebenen Merkmale gelöst. Erfindungsgemäß wird diese Aufgabe ferner durch ein gattungsgemäßes Verfahren mit den im kennzeichnenden Teil des Patentanspruchs 13 angegebenen Merkmalen gelöst.

Besonders bevorzugte Ausführungsformen sind Gegenstand der Unteransprüche.

Bei der erfindungsgemäßen Vorrichtung zur thermischen Behandlung von Substratmaterial können an dem Heizfeld, nahe den Emittoren, als Polygonzug ausgeführte Reflektoren angebracht sein, so daß die Bestrahlung des zu erwärmenden Materials einerseits direkt durch die Emittoren, andererseits indirekt durch die Reflexion an besagten Reflektoren erfolgt.

Die Geometrie des Reflektors ist durch die individuell bemessenen Winkel der einzelnen Teilflächen der Reflektoren zueinander sowie durch deren Flächengrößen so ausgelegt, daß das zu erwärmende Material mit einer weitgehend gleichmäßigen Energiedichte beaufschlagt wird.

In bevorzugten Ausführungsformen sind die Emittoren der erfindungsgemäßen Vorrichtung in Längsrichtung gegeneinander versetzt, so dass ein homogenes Strahlungsfeld sowohl in x-Richtung als auch in y-Richtung erzielt wird.

In einer bevorzugten Ausführungsform der erfindungsgemäßen Vorrichtung ist an der Rückseite der Reflektoren ein vorzugsweise verrippter und/oder flüssigkeitsbefüllter beziehungsweise flüssigkeitsdurchströmter Kühlkörper vorhanden, um die Wärmeableitung zu erhöhen. Vorzugsweise ist der Reflektor und/oder der Kühlkörper in Leichtmetall beziehungsweise hoch wärmeleitfähigem Material ausgeführt.

Nach einer vorteilhaften Weiterbildung ist zusätzlich zu dem primären Frischluftkanal ein sekundärer Frischluftkanal vorhanden, wobei die Luft des sekundären Frischluftkanals zusätzlich zur thermischen Behandlung des Substratmaterials verwendet wird.

In einer vorteilhaften Ausführungsform ist der das zu erwärmende Material aufnehmende Raum zur Seite der Emittoren hin mit einer druckdicht angebrachten, strahlungsdurchlässigen Platte versehen, so daß ein sämtlichen Vorschriften, wie zum Beispiel in VBG und/oder EN vorgesehen, genügender Explosionsschutz gegeben ist.

In einer vorteilhaften Ausgestaltung ist die strahlungsdurchlässige Platte als Spektralfilter ausgeführt, um unerwünschte Strahlungsanteile vom zu behandelnden Substratmaterial fern zu halten.

Nach einer vorteilhaften Weiterbildung der erfindungsgemäßen Vorrichtung sind die Aufnahmepunkte der Emittoren in x-Richtung und/oder in y-Richtung und/oder in z-Richtung verstellbar ausgeführt. Die besagte Verstellung besagter Aufnahmepunkte erfolgt in einer weiteren vorteilhaften Weiterbildung der erfindungsgemäßen Vorrichtung programm- und/oder sensorgesteuert, wodurch insbesondere bei größeren Abständen der einzelnen Emittoren zueinander die Homogenität des Strahlungsfeldes gesteigert wird unsd die Energiedichte der Immission steuerbar ist.

In einer weiteren vorteilhaften Ausgestaltung sind die Reflektoren als Ganzes und/oder eines oder mehrere Reflektoren-Segmente im Anstellwinkel verstellbar. Die besagte Verstellung der Anstellwinkel besagter Reflektoren und/oder Reflektoren-Segmente erfolgt in einer weiteren vorteilhaften Weiterbildung der erfindungsgemäßen Vorrichtung programm- und/oder sensorgesteuert. Hiermit steht ein weiterer Parameter zur Beeinflussung der am zu behandelnden Material auftretenden Energie-Verteilung zur Verfügung.

In einer vorteilhaften Weiterbildung der erfindungsgemäßen Vorrichtung wird der Luftstrom zuerst entlang der Innenwände der erfindungsgemäßen Vorrichtung sowie anschließend an der mindestens einen strahlungsdurchlässigen Platte sowie an den Enden besagter Emittoren vorbeigeführt. Die im Luftstrom befindlichen Innenwände der erfindungsgemäßen Vorrichtung sind zur besseren Wärmeabfuhr vorzugsweise mit einer definierten Rauigkeit und/oder einer Profilierung ausgeführt.

Vorzugsweise besitzt das Heizfeld der erfindungsgemäßen Vorrichtung eine automatische Abschaltung, die über einen Temperaturfühler gesteuert wird. In einer vorteilhaften Ausführungsform der erfindungsgemäßen Vorrichtung ist besagter Temperaturfühler explosionsgeschützt angebracht.

In einer weiteren vorteilhaften Ausgestaltung ist der mindestens eine Luftkanal mit einer Partikel-Sperre und/oder mit einem feinmaschigen Sieb zur Abscheidung von Partikeln versehen.

Nachstehend wird die vorliegende Erfindung anhand von Ausführungsbeispielen näher beschrieben, die schematisch in den Zeichnungen dargestellt sind. Gleiche oder funktionsidentische Bauteile sind hierbei mit denselben Bezugszeichen versehen. Dabei zeigt:
- Figur 1: die schematische Ansicht des Querschnitts durch eine erfindungsgemäße Vorrichtung mit dem Heizelement, mit primärem und sekundärem Luftkanal sowie den strahlungsdurchlässigen Platten;
- Figur 2: die schematische Ansicht des Querschnitts durch eine weitere Ausführungsform einer erfindungsgemäßen Vorrichtung mit Partikelsperre und feinmaschigem Sieb;
- Figur 3: die schematische Ansicht des Querschnitts durch den Reflektor mit Kühlkörper und Emittoren und mit als Polygonzug ausgeführten Reflektor-Flächen;
- Figur 4: den Reflektor mit Kühlkörper gemäß Fig. 3, jedoch in einer Ausführung ohne Kühlkanäle;
- Figur 5: die schematische Ansicht des Querschnitts eines erfindungsgemäßen Reflektors mit einem Kühlkörper mit Kühlkanälen, jedoch ohne Kühlrippen;
- Figur 6: in der Aufsicht schematisch das Heizfeld einer weiteren Ausführungsform der erfindungsgemäßen Vorrichtung mit mehreren Emittor-Kaskaden.

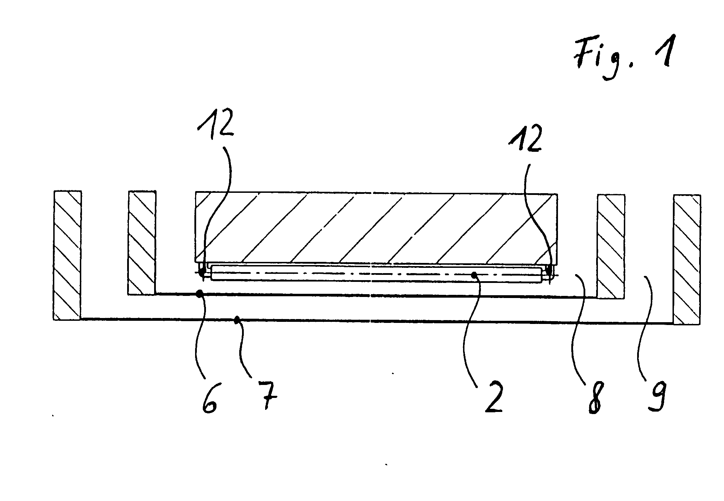

Figur 1 zeigt eine erfindungsgemäße Vorrichtung mit Heizelement 2, mit dem primären Luftkanal 8 und dem sekundären Luftkanal 9, sowie einer ersten strahlungsdurchlässigen Platte 6 und einer zweiten strahlungsdurchlässigen Platte 7. Mindestens die strahlungsdurchlässige Platte 6 ist druckdicht angebracht und gewährleistet somit einen Explosionsschutz. Vorzugsweise ist zusätzlich die strahlungsdurchlässige Platte 7 druckdicht angebracht. In einer vorteilhaften Ausführungsform ist mindestens eine der strahlungsdurchlässigen Platten 6, 7 als Spektralfilter ausgelegt, wodurch unerwünschte Wellenlängen unterdrückt beziehungsweise ausgefiltert werden. Während der thermischen Behandlung des Substratmaterials werden in einer vorteilhaften Ausgestaltung die Aufnahmepunkte 12 der Emittoren 2 in x-Richtung und/oder in y-Richtung und/oder in z-Richtung verstellt, wobei diese Verstellung manuell und/oder sensorgesteuert und/oder programmgesteuert erfolgt, wodurch sich eine definierte Immission am zu behandelnden Substratmaterial erzielen läßt.

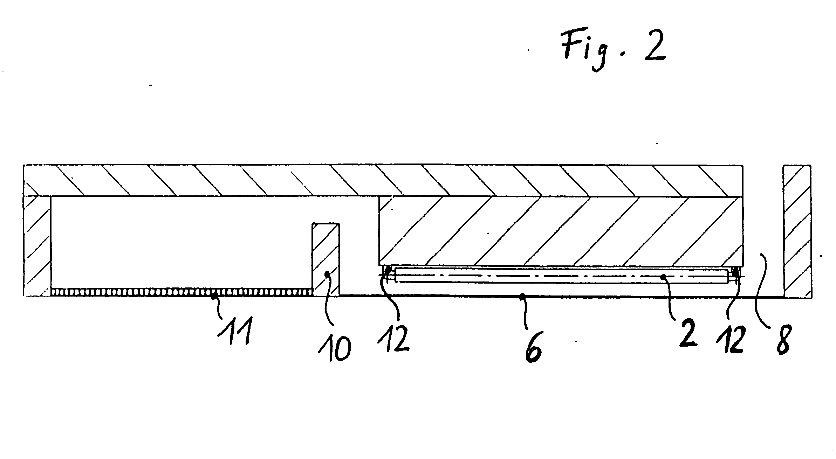

Figur 2 zeigt eine weitere Ausführungsform der erfindungsgemäßen Vorrichtung. Hier sind Emittoren 2, eine strahlungsdurchlässige Platte 6 und eine Partikelsperre 10 in dem einen Luftkanal 8 vorhanden. Ferner ist im Strömungsgang des einen Luftkanals 8 ein feinmaschiges Sieb 11 angebracht, das in Verbindung mit der Partikelsperre 10 alle unerwünschten Partikel abscheidet. Die Partikelsperre 10 beziehungsweise das feinmaschige Sieb 11 können auch an anderer Stelle des Luftkanals angeordnet sein.

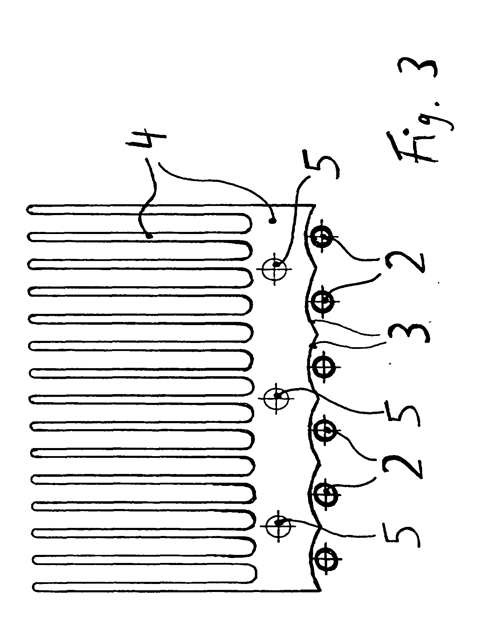

Figur 3 zeigt eine Ausführungsform der erfindungsgemäßen Vorrichtung mit als Polygonzug ausgeführten Reflektoren 3 mit dem Kühlkörper 4, den Kühlkanälen 6 und mit den Emittoren 2. Beim Vorbeifahren des zu behandelnden Substratmaterials an den Emittoren 2 ergibt sich durch die Kombination von direkter und indirekter Strahlung eine weitgehend homogene Immission. Die Wärmeableitung durch den Kühlkörper 4 verhindert punktuelle beziehungsweise zu starke Erwärmung am Reflektor.

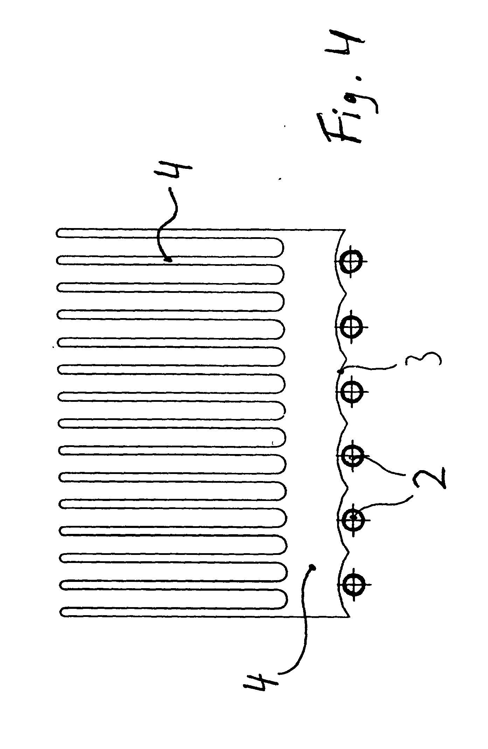

Die Figur 4 zeigt den Reflektor einer erfindungsgemäßen Vorrichtung entsprechend Fig. 3, jedoch ohne Flüssigkeitskühlung. Der Kühlkörper 4 sorgt für die erwünschte Wärmeableitung allein durch direkte Abstrahlung von Wärme in die Umgebung.

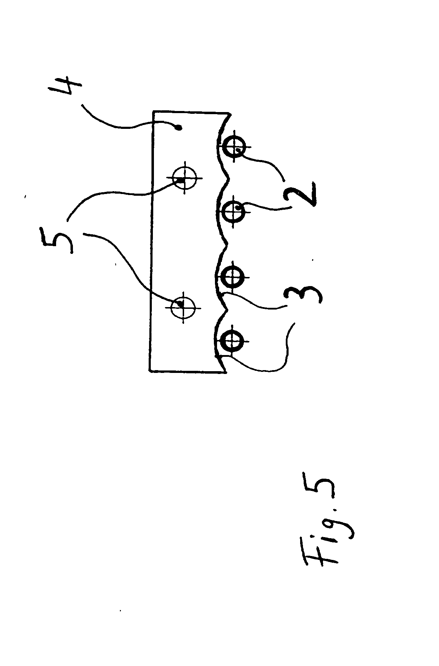

In Figur 5 wird analog zur erfindungsgemäßen Vorrichtung aus Fig. 3 ein Heizfeld 1 mit Emittoren 2 und dem Reflektor 3 gezeigt, wobei der Reflektor 3 ohne auskragende Kühlkörper-Geometrien ausgeführt ist.

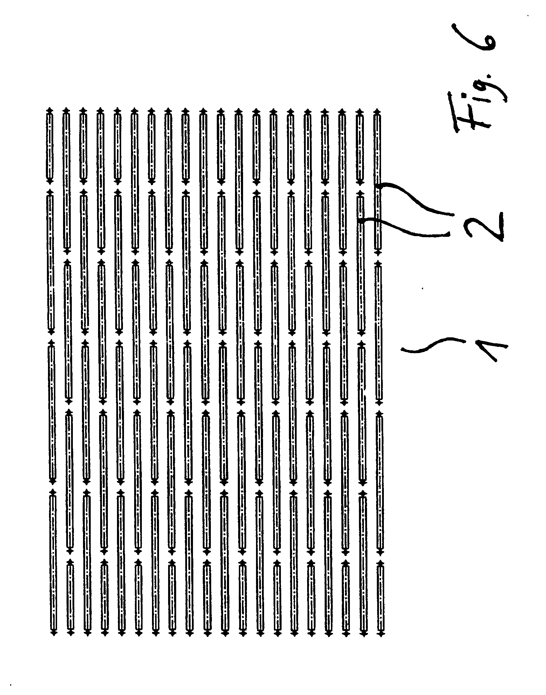

Figur 6 zeigt das Heizfeld 1 einer weiteren Ausfühhrungsform einer erfindungsgemäßen Vorrichtung mit mehreren Kaskaden von Emittoren 2, wobei die Emittoren 2 einer jeden Kaskade relativ zu den Emittoren 2 der benachbarten Kaskade(n) in Längsrichtung gegeneinander versetzt sind. Beim Vorbeiführen des zu behandelnden Substratmaterials ergibt sich so eine besonders große Homogenität des von den Emittoren 2 erzeugten Strahlungsfeldes.

## Patentansprüche

1. Vorrichtung zur homogenen thermischen Behandlung von Substratmaterial, umfassend mehrere stabförmige Infrarot-Emittoren (2) und mindestens einen Reflektor (3) und mindestens eine gegenüber dem Reflektor (3) angeordnete strahlungsdurchlässige Platte (6, 7), wobei jeder Reflektor (3) auf seiner den Emittoren (2) abgewandten Rückseite einen verrippten Kühlkörper (4) aufweist und wobei das hinsichtlich der abgegebenen Strahlungsenergie homogene Heizfeld (1) durch Reflektoren, die eine als Polygonzug gestaltete Geometrie aufweisen, gebildet wird, **dadurch gekennzeichnet, daß** die Arbeitstemperatur der Emittoren (2) mindestens 2500 Grad Kelvin beträgt.

2. Vorrichtung nach Anspruch 1, **dadurch gekennzeichnet, daß** jeder Reflektor (3) auf seiner den Emittoren (2) abgewandten Rückseite einen flüssigkeitsdurchströmten Kühlkörper (4) aufweist.

3. Vorrichtung nach einem der vorhergehenden Ansprüche, **dadurch gekennzeichnet, daß** mindestens eine der strahlungsdurchlässigen Platten (6, 7) ein Spektralfilter ist.

4. Vorrichtung nach einem der vorhergehenden Ansprüche, **dadurch gekennzeichnet, daß** die Reflektoren (3) eine als Polygonzug ausgestaltete Geometrie aufweisen.

5. Vorrichtung nach einem der vorhergehenden Ansprüche, **dadurch gekennzeichnet, daß** der Kühlkörper (4) aus wärmeleitfähigem Material hergestellt ist.

6. Vorrichtung nach einem der vorhergehenden Ansprüche, **dadurch gekennzeichnet, daß** das wärmeleitfähige Material des Kühlkörpers (4) Aluminium ist.

7. Vorrichtung nach einem der vorhergehenden Ansprüche, **dadurch gekennzeichnet, daß** die Emittoren (2) mit Steckverbindungen (12) anbringbar sind und/oder in x-Richtung und/oder y-Richtung und/oder z-Richtung verstellbare Aufnahmepunkte besitzen.

8. Vorrichtung nach einem der vorhergehenden Ansprüche, **dadurch gekennzeichnet, daß** die Reflektoren (3) aus einzelnen Teilflächen bestehen.

9. Vorrichtung nach einem der vorhergehenden Ansprüche, **dadurch gekennzeichnet, daß** die Reflektoren (3) als Ganzes und/oder ihre einzelnen Teilflächen bezüglich ihres Anstellwinkels verstellbar ausgestaltet sind.

10. Vorrichtung nach einem der vorhergehenden Ansprüche, **dadurch gekennzeichnet, daß** sie einen primären Kühlluftkanal (8) und einen sekundären Kühlluftkanal (9) umfaßt.

11. Vorrichtung nach einem der vorhergehenden Ansprüche, **dadurch gekennzeichnet, daß** in dem primären Kühlluftkanal (8) eine Partikelsperre (10) und/oder ein feinmaschiges Gitter (11) vorhanden sind.

12. Vorrichtung nach einem der vorhergehenden Ansprüche, **dadurch gekennzeichnet, daß** sie eine automatische Abschaltung des Heizfeldes (1) umfaßt.

13. Verfahren zur thermischen Behandlung von Substratmaterial, **dadurch gekennzeichnet, daß** das Substratmaterial an der Heizeinrichtung (1) einer Vorrichtung gemäß den Ansprüchen 1 bis 12 vorbeigeführt und dabei mit InfrarotLicht bestrahlt und hierdurch thermisch behandelt wird.

## Claims

1. An apparatus for homogenous thermal treatment of substrate material, comprising a plurality of rod-shaped infra-red emitters (2) and at least one reflector (3) and at least one radiation-transparent plate (6, 7) arranged opposite the reflector (3), each reflector (3) comprising a ribbed heat sink (4) on its rear face facing away from the emitters (2) and the heating field (1), which is homogenous with regard to the radiation energy emitted, being formed by reflectors which have a geometry in the form of a polygonal progression, **characterised in that** the working temperature of the emitters (2) is at least 2500 degrees Kelvin.

2. The apparatus according to claim 1, **characterised in that** each reflector (3) has a heat sink (4), through which fluid flows, on its rear face facing away from the emitters (2).

3. The apparatus according to any one of the preceding claims, **characterised in that** at least one of the radiation-transparent plates (6, 7) is a spectral filter.

4. The apparatus according to any one of the preceding claims, **characterised in that** the reflectors (3) have a geometry in the form of a polygonal progression.

5. The apparatus according to any one of the preceding claims, **characterised in that** the heat sink (4) is produced from thermally conductive material.

6. The apparatus according to any one of the preceding claims, **characterised in that** the thermally conductive material of the heat sink (4) is aluminium.

7. The apparatus according to any one of the preceding claims, **characterised in that** the emitters (2) may be installed with plug connectors (12) and/or have adjustable mounting points in the x direction and/or y direction and/or z direction.

8. The apparatus according to any one of the preceding claims, **characterised in that** the reflectors (3) consist of individual surface portions.

9. The apparatus according to any one of the preceding claims, **characterised in that** the reflectors (3), as a whole and/or their individual surface portions, are configured to be adjustable relative to their angle of incidence.

10. The apparatus according to any one of the preceding claims, **characterised in that** it comprises a primary cool air duct (8) and a secondary cool air duct (9).

11. The apparatus according to any one of the preceding claims, **characterised in that** a particle trap (10) and/or a fine-meshed screen (11) are present in the primary cool air duct (8).

12. The apparatus according to any one of the preceding claims, **characterised in that** it has an automatic cutoff of the heating field (1).

13. A process for thermal treatment of substrate material, **characterised in that** the substrate material is moved past the heating unit (1) of an apparatus according to claims 1 to 12 and is thereby irradiated with infra-red light and, as a result, thermally treated.

## Revendications

1. Dispositif de traitement thermique homogène d'un matériau de substrat, comprenant plusieurs émetteurs à infrarouges (2) en forme de barres et au moins un réflecteur (3) et au moins une plaque (6, 7) transparente au rayonnement, disposée vis-à-vis du réflecteur (3), sur sa face arrière opposée aux émetteurs (2), chaque réflecteur (3) comportant un dissipateur thermique nervuré (4) et la zone chauffante (1) homogène au niveau de l'énergie de rayonnement restituée étant formée par des réflecteurs ayant une géométrie de la forme d'un tracé polygonal, **caractérisé en ce que** la température de fonctionnement des émetteurs (2) est d'au moins 2500 degrés Kelvin.

2. Dispositif selon la revendication 1, **caractérisé en ce que** sur sa face arrière opposée aux émetteurs (2), chaque réflecteur (3) comporte un dissipateur thermique (4) dans lequel circule un liquide.

3. Dispositif selon d'une quelconque des revendications précédentes, **caractérisé en ce qu'**au moins l'une des plaques transparentes au rayonnement (6, 7) est un filtre spectral.

4. Dispositif selon d'une quelconque des revendications précédentes, **caractérisé en ce que** les réflecteurs (3) ont une géométrie de la forme d'un tracé polygonal.

5. Dispositif selon d'une quelconque des revendications précédentes, **caractérisé en ce que** le dissipateur thermique (4) est fabriqué en un matériau thermoconducteur.

6. Dispositif selon d'une quelconque des revendications précédentes, **caractérisé en ce que** le matériau thermoconducteur du dissipateur thermique (4) est de l'aluminium.

7. Dispositif selon d'une quelconque des revendications précédentes, **caractérisé en ce que** les émetteurs (2) sont montables à l'aide de fiches de raccordement (12) ou **en ce qu'**ils comportent en direction **x** et/ou en direction **y** et/ou en direction **z** des points de réception réglables.

8. Dispositif selon d'une quelconque des revendications précédentes, **caractérisé en ce que** les réflecteurs (3) sont constitués de surfaces partielles individuelles.

9. Dispositif selon d'une quelconque des revendications précédentes, **caractérisé en ce que** les réflecteurs (3) sont conçus en tant qu'ensemble et/ou **en ce que** leurs surfaces partielles individuelles sont conçues de façon réglable au niveau de leur angle d'incidence.

10. Dispositif selon d'une quelconque des revendications précédentes, **caractérisé en ce qu'**il comprend un canal d'air de refroidissement primaire (8) et un canal d'air de refroidissement secondaire (9).

11. Dispositif selon d'une quelconque des revendications précédentes, **caractérisé en ce qu'**un bloqueur de particules (10) et/ou un treillis à maillage fin (11) se trouvent dans le canal d'air de refroidissement primaire (11).

12. Dispositif selon d'une quelconque des revendications précédentes, **caractérisé en ce qu'**il comprend une mise à l'arrêt automatique de la zone chauffante (1).

13. Procédé pour le traitement thermique d'un matériau de substrat, **caractérisé en ce que** le matériau de substrat passe devant le système de chauffage (1) d'un dispositif selon les revendications 1 à 12 et qu'à cet effet, il est exposé à un rayonnement infrarouge et donc soumis à un traitement thermique de ce fait.
